# EUROPÄISCHE PATENTANMELDUNG

(11) **EP 4 650 494 A1**
(43) Veröffentlichungstag der Anmeldung: **19.11.2025**
(21) Anmeldenummer: 24176337.4
(22) Anmeldetag: 16.05.2024
(51) Int. Cl.: C30B 15/20, C30B 29/06, C30B 33/02, H01L 21/322

(54) **HALBLEITERSCHEIBE AUS EINKRISTALLINEM SILIZIUM**

(71) Anmelder: Siltronic AG, 81677 München (DE)
(72) Erfinder: Müller, Timo, 84494 Niedertaufkirchen (DE); Gehmlich, Michael, 09600 Weißenborn (DE); Skrobanek, Michael, 09599 Freiberg (DE)
(74) Vertreter: Hasenhütl, Eva

(57) **Zusammenfassung**

Halbleiterscheibe aus einkristallinem Silizium mit einer Vorderseite und einer Rückseite, bestehend aus
einem ringförmigen Randbereich am äußeren Rand der Scheibe, in dem sich die Dicke der Scheibe in Radialauswärtsrichtung verjüngt; und
einen Bereich mit konstanter axialer Dicke bestehend aus N-Gebiet, der innerhalb des ringförmigen Randbereichs angeordnet ist;
wobei der Bereich mit konstanter axialer Dicke einen oberflächennahen Bereich an der Vorderseite, einen oberflächennahen Bereich an der Rückseite und einen zwischen den oberflächennahen Bereichen angeordneten inneren Bereich umfasst; und
der oberflächennahe Bereich an der Vorderseite sich von der Oberfläche der Vorderseite in axialer Richtung bis in eine Tiefe von nicht weniger als 50 µm erstreckt; dadurch gekennzeichnet, dass
eine Konzentration an interstitiellem Sauerstoff im gesamten inneren Bereich nicht weniger als 5,2 x 10¹⁷ Atome/cm³ und nicht mehr als 5,8 x 10¹⁷ Atome/cm³ beträgt und in radialer Richtung um nicht mehr als 0,2 x 10¹⁷ Atome/cm³ variiert; und
eine Konzentration an Stickstoff im oberflächennahen Bereich an der Vorderseite in axialer Richtung von der Oberfläche ins Innere der Halbleiterscheibe abnimmt und in einer Tiefe von 5 µm von der Oberfläche nicht weniger als 1.0 x 10¹⁴ Atome/cm³ und nicht mehr als 1,7 x 10¹⁵ Atome/cm³ beträgt.

## Beschreibung

### Technisches Gebiet

Gegenstand der Erfindung ist eine Halbleiterscheibe aus einkristallinem Silizium.

### Stand der Technik

Für bestimmte elektronische Bauteile sind als Ausgangsmaterial Halbleiterscheiben aus einkristallinem Silizium mit einer besonders hohen mechanischen Stabilität erforderlich. So erfordert die Herstellung von Bauelementen vom BCD-Typ (BIPOLAR-CMOS-DMOS) als Grundmaterial Halbleiterscheiben aus einkristallinem Silizium, die sich durch eine hohe mechanische Robustheit auszeichnen, gerade während Bearbeitungsschritten, die über einen längeren Zeitraum bei vergleichsweise hohen Temperaturen durchgeführt werden müssen. Darüber hinaus müssen solche Scheiben eine Denuded Zone (DZ) mit einer vorgesehenen Tiefe und einen an die DZ angrenzenden Bereich im Inneren der Halbleiterscheibe mit Keimen, die sich zu BMDs (Bulk Micro Defects) mit einer hohen Spitzen-Dichte entwickeln lassen, aufweisen. Unter einer Denuded Zone versteht man einen Bereich des Kristallgitters der Halbleiterscheibe, der frei von BMDs ist und in dem sich mittels der Wärmebehandlung keine BMDs erzeugen lassen.

Der Begriff "Rapid Thermal Annealing" (RTA) beschreibt eine Wärmebehandlung, im Zuge derer eine Halbleiterscheibe vergleichsweise schnell auf eine vergleichsweise hohe Temperatur gebracht, vergleichsweise kurz bei dieser Temperatur gehalten wird und anschließend vergleichsweise schnell abgekühlt wird. Eine Vorrichtung, die zum Durchführen einer RTA-Behandlung geeignet ist, ist in der US 2003 0 029 859 A1 beschrieben. Die Halbleiterscheibe liegt in der Vorrichtung während der RTA-Behandlung auf einem Ring, wird gedreht und von oben einer Wärmestrahlung ausgesetzt.

Eine RTA-Behandlung unter Argon mit einer Haltetemperatur von mehr als 1300 °C erzeugt eine vergleichsweise flache DZ mit einer Tiefe von wenigen Mikrometern, weil Sauerstoff unter solchen Bedingungen in der Nähe der Oberfläche ausdiffundiert. In der US 2012 0 001 301 A1 ist eine solche RTA-Behandlung beschrieben, und dass der Verlust von Sauerstoff eine Schwächung der mechanischen Robustheit der Halbleiterscheibe nach sich zieht. Zur Stärkung der mechanischen Robustheit der Halbleiterscheibe und zur Förderung der BMD-Bildung im Inneren kann die Halbleiterscheibe beispielsweise mit Stickstoff dotiert sein.

Zur Herstellung der Halbleiterscheibe wird beim Ziehen des Einkristalls nach der Czochralski-Methode darauf geachtet, den Quotienten von Ziehgeschwindigkeit v und axialem Temperaturgradienten G an der Phasengrenze zwischen dem Einkristall und der Schmelze derart zu regeln, dass das Kristallgitter bestimmte Eigenschaften in Bezug auf Punktdefekte wie Silizium-Zwischengitteratome und Leerstellen aufweist. Das Dotieren mit Stickstoff während des Ziehens des Einkristalls hat den Nachteil, dass eine vergleichsweise hohe Konzentration an Stickstoff die Bildung von OSF-Defekten (oxygen induced stacking faults) fördert.

Es ist auch bekannt, dass eine RTA-Behandlung unter einer Atmosphäre von Argon und Ammoniak gefolgt von einer RTA-Behandlung unter Argon eine vergleichsweise tiefe DZ hinterlässt (T. Müller et al., "Near-Surface Defect Control by Vacancy Injecting/Out-Diffusing Rapid thermal Annealing", Phys. Status Solidi A, 2019, 1900325). Die EP 4 151 782 B1 beschreibt ein Verfahren zur Herstellung einer Halbleiterscheibe aus einkristallinem Silizium mit einer Vorderseite und einer Rückseite, bestehend aus N-Gebiet, umfassend eine Konzentration an interstitiellem Sauerstoff von nicht weniger als 5,3 × 10¹⁷ Atome/cm³ und nicht mehr als 5,9 × 10¹⁷ Atome/cm³; und eine Konzentration an Stickstoff, die jeweils von der Vorderseite und von der Rückseite ins Innere der Halbleiterscheibe abnimmt und in einer Tiefe von 50 µm von der Vorderseite nicht weniger als 2,0 × 10¹⁵ Atome/cm³ beträgt. Das Verfahren der EP 4 151 782 B1 umfasst eine erste, zweite und dritte RTA-Behandlung.

### Technische Aufgabe der Erfindung und deren Lösung

Eine weitere Verbesserung der mechanischen Robustheit solcher Halbleiterscheiben aus einkristallinem Silizium, ohne mit OSF-Defekten belastet zu sein, ist insbesondere für die Herstellung von Bauelementen vom BCD-Typ erforderlich.

Es ist daher die Aufgabe der vorliegenden Erfindung, eine Halbleiterscheibe aus einkristallinem Silizium bereitzustellen, die eine gegenüber dem Stand der Technik erhöhte mechanische Robustheit aufweist, ohne mit OSF-Defekten belastet zu sein. Darüber hinaus soll die Halbleiterscheibe zur Verbesserung der Effizienz in der Herstellung von Bauelementen einen möglichst geringen Randausschluss aufweisen. Die Aufgabe wird gelöst durch die erfindungsgemäße Halbleiterscheibe aus einkristallinem Silizium.

Die erfindungsgemäße Halbleiterscheibe aus einkristallinem Silizium mit einer Vorderseite und einer Rückseite besteht aus
einem ringförmigen Randbereich am äußeren Rand der Scheibe, in dem sich die Dicke der Scheibe in Radialauswärtsrichtung verjüngt; und
einen Bereich mit konstanter axialer Dicke bestehend aus N-Gebiet, der innerhalb des ringförmigen Randbereichs angeordnet ist;
wobei der Bereich mit konstanter axialer Dicke einen oberflächennahen Bereich an der Vorderseite, einen oberflächennahen Bereich an der Rückseite und einen zwischen den oberflächennahen Bereichen angeordneten inneren Bereich umfasst; und
der oberflächennahe Bereich an der Vorderseite sich von der Oberfläche der Vorderseite in axialer Richtung bis in eine Tiefe von nicht weniger als 50 µm erstreckt;
dadurch gekennzeichnet, dass
eine Konzentration an interstitiellem Sauerstoff im gesamten inneren Bereich nicht weniger als 5,2 × 10¹⁷ Atome/cm³ und nicht mehr als 5,8 × 10¹⁷ Atome/cm³ beträgt und in radialer Richtung um nicht mehr als 0,2 × 10¹⁷ Atome/cm³ variiert; und
eine Konzentration an Stickstoff im oberflächennahen Bereich an der Vorderseite in axialer Richtung von der Oberfläche ins Innere der Halbleiterscheibe abnimmt und in einer Tiefe von 5 µm von der Oberfläche nicht weniger als 1.0 × 10¹⁴ Atome/cm³ und nicht mehr als 1,7 × 10¹⁵ Atome/cm³ beträgt.

### Kurzbeschreibung der Figuren

**Fig. 1** zeigt die mittels LT-FTIR bestimmte Konzentration an interstitiellem Sauerstoff in den im Ausführungsbeispiel hergestellten Scheiben aus einkristallinem Silizium in Abhängigkeit von der radialen Position in einem Bereich der in radialer Richtung nicht weniger als 140 mm und nicht mehr als 151 mm von der Rotationsachse entfernt ist.
**Fig. 2** zeigt Karten des mechanischen Stresses in den erfindungsgemäßen Halbleiterscheiben. Der mechanische Stress wurde mittels SIRD bestimmt.
**Fig. 3** zeigt die mittels LT-FTIR bestimmte Konzentration an interstitiellem Sauerstoff in den im Vergleichsbeispiel hergestellten Halbleiterscheiben in Abhängigkeit von der radialen Position in einem Bereich der in radialer Richtung nicht weniger als 140 mm und nicht mehr als 151 mm von der Rotationsachse entfernt ist.
**Fig. 4** zeigt Karten des mechanischen Stresses in den im Vergleichsbeispiel hergestellten Halbleiterscheiben. Der mechanische Stress wurde mittels SIRD bestimmt.

### Detaillierte Beschreibung der Erfindung

Die erfindungsgemäße Halbleiterscheibe aus einkristallinem Silizium kann einen Durchmesser von nicht weniger als 200 mm und nicht mehr als 450 mm haben und hat vorzugsweise einen Durchmesser von nicht weniger als 300 mm und nicht mehr als 310 mm, besonders bevorzugt nicht weniger als 301 mm und nicht mehr als 305 mm. Die erfindungsgemäße Halbleiterscheibe hat vorzugsweise eine Dicke von nicht weniger als 500 µm und nicht mehr als 1500 µm, besonders bevorzugt nicht weniger als 700 µm und nicht mehr als 1000 µm.

Die erfindungsgemäße Halbleiterscheibe besteht aus einem ringförmigen Randbereich am äußeren Rand der Scheibe, in dem sich die Dicke der Scheibe in Radialauswärtsrichtung verjüngt. Dabei ist unter der Dicke der Scheibe die axiale Ausdehnung senkrecht zur radialen Richtung zu verstehen, also senkrecht zu den Hauptflächen an der Vorder- und Rückseite der Scheibe. Der Randbereich am äußeren Rand der Scheibe ist vorzugsweise dadurch gekennzeichnet, dass in ihm die axiale Ausdehnung der Halbleiterscheibe in Radialauswärtsrichtung kontinuierlich abnimmt. Der ringförmige Randbereich ist also derjenige Bereich der Scheibe, der durch das umlaufende Kantenprofil gebildet wird. Vorzugsweise hat der ringförmige Randbereich eine radiale Ausdehnung von nicht weniger als 100 µm und nicht mehr als 600 µm, mehr bevorzugt nicht weniger als 150 µm und nicht mehr als 500 µm.

Die erfindungsgemäße Halbleiterscheibe umfasst einen Bereich mit konstanter axialer Dicke, bestehend aus N-Gebiet, welcher innerhalb des ringförmigen Randbereichs angeordnet ist. Der Bereich mit konstanter axialer Dicke grenzt vorzugsweise direkt an den ringförmigen Randbereich an. Demensprechend hat der Bereich mit konstanter axialer Dicke in radialer Richtung vorzugsweise eine zylindrische Form. Die Rotationsachse des Zylinders fällt dabei mit der der Halbleiterscheibe zusammen. Wenn die erfindungsgemäße Halbleiterscheibe einen Durchmesser von nicht weniger als 300 mm und nicht mehr als 310 mm hat, dann weist der Bereich mit konstanter axialer Dicke vorzugsweise eine radiale Ausdehnung von nicht weniger als 290 mm und nicht mehr als 309 mm, mehr bevorzugt eine radiale Ausdehnung von nicht weniger als 295 mm und nicht mehr als 299 mm, auf. Die Halbleiterscheibe kann eine (100)-Orientierung, eine (110)-Orientierung oder eine (111)-Orientierung aufweisen und hat bevorzugt eine (100)-Orientierung.

Das N-Gebiet ist dadurch gekennzeichnet, dass in ihm keine Agglomerate von Silizium-Zwischengitteratomen oder von Leerstellen mit einem Durchmesser von mehr als 20 nm, vorzugsweise keine solche Agglomerate mit einem Durchmesser von mehr als 15 nm vorhanden sind. Vorzugsweise ist im N-Gebiet die Konzentration an Agglomeraten von Silizium-Zwischengitteratomen und Leerstellen mit einem Durchmesser von nicht mehr als 15 nm nicht mehr als 3,0 × 10⁵ cm⁻³.

Der Bereich mit konstanter axialer Dicke umfasst einen oberflächennahen Bereich an der Vorderseite, einen oberflächennahen Bereich an der Rückseite und einen zwischen den oberflächennahen Bereichen angeordneten inneren Bereich. In einer Ausführungsform besteht der Bereich mit konstanter axialer Dicke ausschließlich aus dem oberflächennahen Bereich an der Vorderseite, dem oberflächennahen Bereich an der Rückseite und dem zwischen den oberflächennahen Bereichen angeordneten inneren Bereich.

Der oberflächennahe Bereich an der Vorderseite erstreckt sich von der Oberfläche der Vorderseite in axialer Richtung bis in eine Tiefe von nicht weniger als 50 µm, vorzugsweise nicht weniger als 100 µm. Vorzugsweise erstreckt sich der oberflächennahe Bereich an der Vorderseite von der Oberfläche der Vorderseite in axialer Richtung bis in eine Tiefe von nicht mehr als 200 µm, vorzugsweise nicht mehr als 150 µm. In einer Ausführungsform erstreckt sich der oberflächennahe Bereich an der Vorderseite von der Oberfläche der Vorderseite in axialer Richtung bis in eine Tiefe von nicht weniger als 50 µm und nicht mehr als 150 µm. In einer Ausführungsform erstreckt sich auch der oberflächennahe Bereich an der Rückseite von der Oberfläche der Rückseite in axialer Richtung bis in eine Tiefe von nicht weniger als 50 µm und nicht mehr als 150 µm.

Während des Ziehens eines Einkristalls nach der Czochralski-Methode wird Sauerstoff größtenteils auf Zwischengitterplätzen des Kristalls eingebaut. Der Sauerstoff auf Zwischengitterplätzen wird als interstitieller Sauerstoff bezeichnet. Die Konzentration an interstitiellem Sauerstoff beträgt im gesamten inneren Bereich nicht weniger als 5,2 × 10¹⁷ Atome/cm³ und nicht mehr als 5,8 × 10¹⁷ Atome/cm³, vorzugsweise nicht weniger als 5,3 × 10¹⁷ Atome/cm³ und nicht mehr als 5,7 × 10¹⁷ Atome/cm³. Die Konzentration an interstitiellem Sauerstoff variiert im gesamten inneren Bereich um nicht mehr als 0,2 × 10¹⁷ Atome/cm³, vorzugsweise um nicht mehr als 0,1 × 10¹⁷ Atome/cm³. Da die Konzentration an interstitiellem Sauerstoff vor allem am Scheibenrand abfällt, kann die Variation der Konzentration an interstitiellem Sauerstoff dadurch bestimmt werden, dass der radiale Konzentrationsverlauf an interstitiellem Sauerstoff am äußeren Rand des inneren Bereichs, also dem Bereich, der an den Randbereich der Halbleiterscheibe angrenzt, gemessen wird, vorzugsweise in einem ringförmigen Bereich mit einer radialen Ausdehnung von nicht weniger als 3 mm am äußeren Rand des inneren Bereiches.

Die Konzentration an interstitiellem Sauerstoff kann mit LT-FTIR gemessen werden. Die Konzentration an interstitiellem Sauerstoff wird vorzugsweise gemäß der Norm SEMI MF1188-1107 bestimmt. Um die Konzentration an interstitiellem Sauerstoff in einer bestimmten Tiefe im inneren Bereich der Halbleiterscheibe messen zu können, kann der oberflächennahe Bereich entweder durch Ätzen entfernt werden, oder die Halbleiterscheibe gebrochen und am Querschnittsprofil an der Bruchkante gemessen werden.

Die Variation der Konzentration an interstitiellem Sauerstoff im inneren Bereich der Halbleiterscheibe wird vorzugsweise dadurch bestimmt, dass die Konzentration an interstitiellem Sauerstoff in einem ringförmigen Bereich mit einer radialen Ausdehnung von nicht weniger als 3 mm am äußeren Rand des inneren Bereiches in radialen Abständen von nicht mehr als 0,5 mm gemessen wird, und die Differenz aus dem höchsten und dem niedrigsten gemessen Wert der Konzentration an interstitiellem Sauerstoff gebildet wird.

Vorzugsweise beträgt die Konzentration an interstitiellem Sauerstoff im gesamten inneren Bereich nach einer Wärmebehandlung nicht weniger als 4,40 × 10¹⁷ Atome/cm³ Die Wärmebehandlung umfasst (i) einen ersten Schritt, in dem die Halbleiterscheibe einer Atmosphäre aus einer Mischung von Sauerstoff und Stickstoff mit einem Volumen-Verhältnis von O₂:N₂ von 1:10 über einen Zeitraum von 4 Stunden bei einer Temperatur von 800 °C ausgesetzt wird; und (ii) einen zweiten Schritt, in dem die Halbleiterscheibe einer Atmosphäre aus einer Mischung von Sauerstoff und Stickstoff mit einem Volumen-Verhältnis von O₂:N₂ von 1:10 über einen Zeitraum von 16 Stunden bei einer Temperatur von 1000 °C ausgesetzt wird.

Vorzugsweise nimmt die Konzentration an interstitiellem Sauerstoff im gesamten inneren Bereich nach der oben beschriebenen Wärmebehandlung um nicht mehr als 1,30 × 10¹⁷ Atome/cm³, besonders bevorzugt um nicht mehr als 1,00 × 10¹⁷ Atome/cm³ ab. Die Abnahme der Konzentration an interstitiellem Sauerstoff an einer bestimmten Stelle des inneren Bereichs entspricht dabei der Differenz der an dieser Stelle gemessenen Sauerstoffkonzentration vor und nach der oben beschriebenen Wärmebehandlung.

Die oben beschriebene zweistufige Wärmebehandlung entspricht der in der EP 4 151 782 B1 beschriebenen Wärmebehandlung zur Entwicklung von BMDs. Somit gibt die Konzentration an interstitiellem Sauerstoff nach der zweistufigen Wärmebehandlung Auskunft über die Sauerstoffkonzentration, nachdem bereits BMDs erzeugt wurden. Ein zu großer Verlust von Sauerstoff durch die Wärmebehandlung zieht eine Schwächung der mechanischen Robustheit der Halbleiterscheibe nach sich. Deshalb ist es wünschenswert, dass die Konzentration an interstitiellem Sauerstoff durch die zweistufige Wärmebehandlung nicht zu stark abnimmt und einen bestimmten Schwellenwert nicht unterschreitet.

Die Konzentration an Stickstoff nimmt im oberflächennahen Bereich an der Vorderseite in axialer Richtung von der Oberfläche ins Innere der Halbleiterscheibe ab und beträgt in einer Tiefe von 5 µm von der Oberfläche nicht weniger als 1.0 × 10¹⁴ Atome/cm³ und nicht mehr als 1,7 × 10¹⁵ Atome/cm³, vorzugsweise weniger als 1,5 × 10¹⁵ Atome/cm³. Die Vorderseite ist diejenige Seite der Halbleiterscheibe, die während der RTA-Behandlung oben liegt. In einer Ausführungsform nimmt auch die Konzentration an Stickstoff im oberflächennahen Bereich an der Rückseite in axialer Richtung von der Oberfläche ins Innere der Halbleiterscheibe ab. Die Konzentration an Stickstoff wird vorzugsweise mit LT-FTIR gemessen. Vorzugsweise ist die Stickstoffkonzentration im oberflächennahen Bereich an der Vorderseite höher als im oberflächennahen Bereich an der Rückseite, bei gleicher Entfernung in axialer Richtung von der jeweiligen Oberfläche. Die Konzentration an Stickstoff im oberflächennahen Bereich an der Rückseite der Halbleiterscheibe beträgt vorzugsweise nicht weniger als 30% und nicht mehr als 70% der Konzentration an Stickstoff im oberflächennahen Bereich an der Vorderseite der Halbleiterscheibe, bei gleicher Entfernung in axialer Richtung von der jeweiligen Oberfläche. Im Inneren dazwischen, also zwischen den oberflächennahen Bereichen an der Vorder- und Rückseite, sinkt die Konzentration auf ein Minimum, das der Konzentration an Stickstoff im Einkristall entspricht, von dem die Halbleiterscheibe stammt. Die Konzentration an Stickstoff nimmt im oberflächennahen Bereich an der Vorderseite und im oberflächennahen Bereich an der Rückseite in axialer Richtung von der Oberfläche ins Innere der Halbleiterscheibe monoton ab, aber nicht zwingend streng monoton. So bleibt die Konzentration an Stickstoff im oberflächennahen Bereich an der Vorder- und Rückseite in Radialinwärtsrichtung konstant, sobald der Minimalwert der Konzentration an Stickstoff erreicht ist.

Die Konzentration an Kohlenstoff in dem Bereich mit konstanter axialer Dicke beträgt vorzugsweise nicht mehr als 5,0 × 10¹⁵ Atome/cm³. Die Kohlestoffkonzentration kann dadurch verringert werden, dass der Eintrag von Kohlestoff während des Ziehens des Einkristallstabs aus dem Gasstrom in den Tiegel verringert wird. Dies kann beispielsweise durch die Verwendung eines Quarztiegels mit einer erhöhten Wandhöhe von nicht weniger 58 cm und einem Durchmesser von 32 Zoll erreicht werden, wodurch auch die Ausbildung von SD-COPS verringert werden kann. Die Konzentration an Kohlenstoff wird vorzugsweise mittels FTIR bestimmt.

Nach der oben beschriebenen, zweistufigen Wärmebehandlung weist die Halbleiterscheibe vorzugsweise (i) eine Denuded Zone auf, die sich in axialer Richtung von der Oberfläche der Vorderseite bis zu einer Tiefe von nicht weniger als 10 µm ins Innere der Halbleiterscheibe erstreckt, und (ii) einen darunter liegenden Bereich mit BMDs einer Dichte von vorzugsweise 1,1 × 10¹⁰ cm⁻³ bis 1,3 × 10¹⁰ cm⁻³. Vorzugsweise hat die Denuded Zone eine Ausdehnung oder Tiefe in axialer Richtung von der Oberfläche der Vorderseite bis ins Innere von nicht mehr als 20 µm. Die Denuded Zone hat eine Dichte an Leerstellen von nicht mehr als 1 × 10¹³ Leerstellen/cm³, vorzugsweise nicht mehr als 7 × 10¹² Leerstellen/cm³, bestimmt mittels Platin Diffusion und/oder DLTS (deep level transient spectroscopy).

Die Halbleiterscheiben können thermischem Stress in einem Abscheidereaktor zum Abscheiden einer epitaktischen Schicht unterworfen werden, um deren mechanische Robustheit zu testen. In einem solchen Abscheidereaktor liegt die Halbleiterscheibe zwischen oberen und unteren Lampenbänken, die Wärmestrahlung auf die Rückseite und die Vorderseite der Halbleiterscheibe richten. Der Test kann derart konzipiert werden, dass die Halbleiterscheibe in einem bestimmten ringförmigen Bereich mit einer radialen Breite von 10 mm mit einer Temperatur von 1150°C um 5 °C stärker erhitzt wird, als der von diesem ringförmigen Bereich umschlossene, radialinwärtsliegende Bereich der Halbleiterscheibe. Anschließend wird die Halbleiterscheibe mittels SIRD (Scanning Infra-Red Depolarization) untersucht. SIRD nutzt das physikalische Prinzip, dass linear polarisiertes Licht in der Polarisationsrichtung verändert wird, wenn es durch einen Bereich fällt, der unter mechanischem Stress steht. Auf die Halbleiterscheibe gestrahlte Infrarot-Strahlung wird in Bereichen des Kristallgitters depolarisiert, in denen thermische Spannungen das Kristallgitter beschädigt haben. Je stärker die Schädigung, desto höher ist die in Depolarisations-Einheiten (DU) gemessene Depolarisierung. Auf den erfindungsgemäßen Halbleiterscheibe wird bei nicht mehr als 2,0% der untersuchten Fläche eine Schwelle des Betrags der Depolarisierung von 30 DU überschritten, vorzugsweise sogar bei nicht mehr als 1,5% der untersuchten Fläche. Bei Halbleiterscheibe aus dem Stand der Technik, beispielsweise den Halbeiterscheiben der Ausführungsbeispiele der EP 4 151 782 B1, beträgt der Anteil der untersuchten Fläche, der eine Schwelle des Betrags der Depolarisierung von 30 DU überschreitet, mehr als 5 %.

Die erfindungsgemäße Halbleiterscheibe hat vorzugsweise eine Konzentration an COPs mit einer Größe von nicht mehr als 15 nm von nicht mehr als 3,0 × 10⁵ cm⁻³. COPS mit einer Größe von nicht mehr als 15 nm können, wie BMDs, mittels IR-LST (Infrared light scattering tomography) detektiert werden.

Die erfindungsgemäße Halbleiterscheibe hat vorzugsweise eine Dichte an SD-COP-Defekten von nicht mehr als 1250 pro cm². SD-COPs sind Defekte, die bei einer thermischen Behandlung bei über 900°C für einen Zeitraum von mindestens zwei Stunden erzeugt werden können. SD-COP-Defekten umfassen oxidierte COPs mit einer Größe von weniger als 15 nm und LPITS. SD-COPS werden nach einer Ätze, vorzugsweise mit der Ätzflüssigkeit Secco (Kaliumdichromat (K₂Cr₂O₇) in Flusssäure und Wasser), mittels eines optischen Profilometers oder mikroskopisch bestimmt. SD-COPs können auch mit Hilfe der in der US 5,980,720 beschriebenen Präparations- und Analysemethode oder auch mittels Laser-Streulicht-Topographie nachgewiesen werden. Weiterhin lassen sich SD-COPs auch als "Flow Pattern Defects" (FPD) mittels Secco-Ätze und optischer Inspektion detektieren.

Durch das Secco-Ätzen werden Ätzgruben einer bestimmten Größe, die auch als LPITs (large etch pits) bezeichnet werden, freigelegt. LPITs, können beispielsweise mittels optischer Inspektion detektieren werden. Auf einer erfindungsgemäßen Halbleiterscheibe werden nach dem Ätzen keine LPITs detektiert. Dies zeigt, dass keine Agglomerate von Silizium-Zwischengitteratomen mit einem Durchmesser von mehr als 20 nm vorliegen. Vorzugsweise liegen auf einer erfindungsgemäßen Halbleiterscheibe keine Agglomerate von Silizium-Zwischengitteratomen mit einem Durchmesser von mehr als 15 nm vorliegen.

Zur Herstellung der erfindungsgemäßen Halbleiterscheibe aus einkristallinem Silizium kann ein Verfahren herangezogen werden, welches die folgenden Schritte in dieser Reihenfolge umfasst:
(i) Ziehen eines Einkristallstabs mit einem zylindrischen Abschnitt nach der Czochralski-Methode aus einer Schmelze aus Silizium, die in einem Tiegel enthalten ist; wobei
   die Ziehgeschwindigkeit während des Ziehens des zylindrischen Abschnittes nicht weniger als 0,40 mm/min und nicht mehr als 0,60 mm/min beträgt,
   die Schmelze mit einem horizontalen Magnetfeld beaufschlagt ist,
   der Tiegel während des Ziehens des zylindrischen Abschnitts des Einkristalls gedreht wird;
   die Drehrichtung des Tiegels mit einer Periode von nicht weniger als 15 Sekunden und nicht mehr als 30 Sekunden gewechselt wird, und
   die Amplitude der Drehgeschwindigkeit des Tiegels nicht weniger als 0,3 U/min und nicht mehr als 6,0 U/min beträgt und während des Ziehens des zylindrischen Abschnittes kontinuierlich erhöht wird;
(ii) das Abtrennen von mindestens einer Halbleiterscheibe aus dem zylindrischen Abschnitt des Einkristallstabs;
(iii) eine erste RTA-Behandlung der Halbleiterscheibe bei einer Zieltemperatur in einem ersten Temperaturbereich von nicht weniger als 700 °C und nicht mehr als 1000 °C über einen Zeitraum von nicht weniger als 10 s und nicht mehr als 20 s in einer ersten Atmosphäre aus Argon und Ammoniak im Volumen-Verhältnis von nicht weniger als 1:1,5 und nicht mehr als 1:0,9;
(iv) eine zweite RTA-Behandlung der Halbleiterscheibe bei einer Zieltemperatur in einem zweiten Temperaturbereich von nicht weniger als 1180 °C und nicht mehr als 1220 °C über einen Zeitraum von nicht weniger als 20 s und nicht mehr als 30 s in einer zweiten Atmosphäre aus Argon; und
(v) eine dritte RTA-Behandlung der Halbleiterscheibe bei einer Zieltemperatur in einem dritten Temperaturbereich von nicht weniger als 1160 °C und nicht mehr als 1170 °C über einen Zeitraum von nicht weniger als 10 s und nicht mehr als 20 s in einer dritten Atmosphäre aus Argon und Ammoniak im Volumen-Verhältnis von nicht weniger als 9:10 und nicht mehr als 2,75:2.

Dieses Verfahren wird im Folgenden genauer ausgeführt.

Zur Herstellung der erfindungsgemäßen Halbleiterscheibe aus einkristallinem Silizium wird zunächst ein Einkristall nach der Czochralski-Methode gezogen. Beim Ziehen des Einkristalls nach der Czochralski-Methode aus einer Schmelze aus Silizium, die in einem Tiegel enthalten ist, in einer Atmosphäre aus Argon und Wasserstoff, ist darauf zu achten, den Quotienten von Ziehgeschwindigkeit v und dem axialem Temperaturgradienten G an der Phasengrenze zwischen dem Einkristall und der Schmelze derart zu regeln, dass der zylindrische Abschnitt des Einkristalls nur aus N-Gebiet besteht. Der Koeffizient v/G der Ziehgeschwindigkeit v und des thermischen Gradienten G an der Grenzfläche weist während des Ziehens des zylindrischen Abschnitts des Einkristalls vorzugsweise drei Rampen entlang der Ziehachse auf. Die Ziehgeschwindigkeit v beträgt vorzugsweise mehr als 0,45 mm/min und weniger als 0,50 mm/min. Diese Bedingungen ermöglichen es, SD-COP Defekte zu verringern.

Die Schmelze wird mit einem horizontalen Magnetfeld beaufschlagt und der Tiegel während des Ziehens des zylindrischen Abschnitts des Einkristalls gedreht, wobei die Drehrichtung regelmäßig mit einer Periode von nicht weniger als 15 Sekunden und nicht mehr als 30 Sekunden gewechselt wird. Die Amplitude der Drehgeschwindigkeit beträgt nicht weniger als 0,3 U/min und nicht mehr als 6,0 U/min. Die Amplitude wird während des Ziehens des zylindrischen Abschnitts des Einkristalls, vorzugsweise über einen Längenbereich, der von 20-25% bis zu 90-100% der Gesamtlänge des Kristallstabs reicht, kontinuierlich auf 6,0 U/min erhöht. Dadurch kann die Grenzflächendicke periodisch erhöht und dadurch der Sauerstoffeintrag in die Schmelze geregelt werden. Der Sauerstoffeintrag wiederum bestimmt den Einbau von interstitiellem Sauerstoff in den wachesenden Einkristall. Der Einkristall wird nicht absichtlich mit Stickstoff dotiert. Die Konzentration an Stickstoff im zylindrischen Abschnitt des Einkristalls beträgt deshalb nicht mehr als 1,0 × 10¹² Atome/cm³ Der zylindrische Abschnitt des Einkristalls hat dabei einen Durchmesser im Bereich von 312 bis 315 mm.

In einem anschließenden Schleifschritt wird der Durchmesser des zylindrischen Abschnittes des Einkristallstabs auf 310 mm oder weniger verringert und der zylindrische Abschnitt des Einkristallstabes gesägt, geschliffen, die Kanten verrundet, poliert und chemisch gereinigt. So werden Scheiben mit einem Durchmesser von nicht weniger als 300 mm und nicht mehr als 310 mm, vorzugsweise nicht weniger als 301 mm und nicht mehr als 305 mm, erhalten.

Mit dem oben beschriebenen Herstellungsverfahren werden Halbleiterscheiben erhalten, die ausschließlich aus N-Gebiet bestehen, in dem keine Agglomerate von Silizium-Zwischengitteratomen oder Leerstellen mit einem Durchmesser von mehr als 20 nm, vorzugsweise von mehr als 15 nm, vorhanden sind. Vorzugsweise umfasst das N-Gebiet mindestens eine Nᵢ-Domäne, in der Silizium-Zwischengitteratome als Punktdefektart dominieren, und mindestens eine Nᵥ-Domäne, in der Leerstellen als Punktdefektart dominieren.

Um die erfindungsgemäßen Halbleiterscheiben zu erhalten, müssen die im oben beschriebenen Verfahren hergestellten polierte Halbleiterscheiben den folgenden drei RTA-Behandlungen unterzogen werden.

Im Zuge der ersten RTA-Behandlung wird die Halbleiterscheibe vorzugsweise auf eine Zieltemperatur in einem ersten Temperaturbereich von nicht weniger als 700 °C und nicht mehr als 1000 °C erhitzt und über einen Zeitraum von nicht weniger als 10 s und nicht mehr als 20 s auf der Zieltemperatur in einer ersten Atmosphäre aus Argon (Ar) und Ammoniak (NH₃) im Volumen-Verhältnis von nicht weniger als 1:1,5 und nicht mehr als 1:0,9 gehalten.

Die zweite RTA-Behandlung der Halbleiterscheibe wird bei einer Temperatur in einem zweiten Temperaturbereich von nicht weniger als 1180 °C und nicht mehr als 1220 °C über einen Zeitraum von nicht weniger als 20 s und nicht mehr als 30 s in einer zweiten Atmosphäre aus Argon durchgeführt.

Die dritte RTA-Behandlung der Halbleiterscheibe wird bei einer Temperatur in einem dritten Temperaturbereich von nicht weniger als 1160 °C und nicht mehr als 1170 °C über einen Zeitraum von nicht weniger als 10 s und nicht mehr als 20 s in einer dritten Atmosphäre aus Argon und Ammoniak im Volumen-Verhältnis von nicht weniger als 9:10 und nicht mehr als 2,75:2 durchgeführt.

Die erste und die dritte RTA-Behandlung stellen Schritte dar, die die Vorderseite der Halbleiterscheibe und in geringerem Maße die Rückseite der Halbleiterscheibe nitridieren. In Kombination mit der zweiten RTA-Behandlung wird Stickstoff in den oberflächennahen Bereich der Halbleiterscheibe diffundiert. Auf diese Weise gelangen bis zu 2 × 10¹⁵ Atome/cm³ an Stickstoff in den oberflächennahen Bereich der Halbleiterscheibe und sorgen für eine ausreichende Robustheit des Kristallgitters. Eine durch Stickstoff induzierte Bildung von OSF-Defekten im inneren Bereich der Halbleiterscheibe findet nicht statt, weil dort die dafür notwendige Konzentration an Stickstoff nicht erreicht wird.

Vorzugsweise werden die Halbleiterscheiben für die RTA-Behandlungen bis zu einer Temperatur von 1200°C mit einer Geschwindigkeit von 60 K/s bis 70 K/s und ab einer Temperatur von 1200°C mit einer Geschwindigkeit von 15 K/s bis 20 K/s erhitzt. Nach der letzten RTA-Behandlung werden die Halbleiterscheibe vorzugsweise mit einer Geschwindigkeit von 30 K/s von der Zieltemperatur der letzten RTA-Behandlung abgekühlt.

In JP 2015-73049 A wird gezeigt, dass thermisch induzierte Versetzungen mittels SIRD und einer BFA-Analyse (Bad-Fraction-Area) quantitativ beschrieben werden können. Gemäß JP 2006-269896 A beeinflussen die Dauer und die Temperatur der Wärmebehandlung das Auftreten von thermisch induzierten Versetzungen. Die Widerstandsfähigkeit von Halbleiterscheiben aus einkristallinem Silizium gegen thermisch induzierte Versetzungen kann demensprechend gemäß dem folgenden Verfahren getestet werden.

Die Widerstandsfähigkeit von Halbleiterscheiben aus einkristallinem Silizium gegen thermisch induzierte Versetzungen wird vorzugsweise gemäß dem folgenden Verfahren getestet. Das im Folgenden beschriebene Verfahren zum Testen der Widerstandsfähigkeit gegen thermisch induzierte Versetzungen wurde herangezogen, um zu beurteilen, ob die Scheibe frei von thermisch induzierten Versetzungen (Slips) ist. Diese Verfahren umfasst die folgenden Schritte (a) bis (c).
(a) Die Halbleiterscheiben der vorliegenden Erfindung kann einer Wärmebehandlung in einem Vertikalofen, beispielsweise einem Gerät von ASM International NV, unterzogen werden, wobei jede Halbleiterscheibe auf drei Fingern eines Boots (long finger boat, beispielsweise des Herstellers Ferrotec Materials Technologies Corporation) aufliegt. Während der Wärmebehandlung besteht also ein Kontakt zwischen der Halbleiterscheibe und den Fingern des Boots.
   In der Wärmebehandlung wurde die Halbleiterscheibe bis zu einer Temperatur von 1000°C mit einer Geschwindigkeit von 5 K/min, im Temperaturbereich von 1000°C bis 1200°C mit einer Geschwindigkeit von 2 K/min oder weniger, vorzugsweise 0,5 K/min, erhitzt, bei 1200°C für 10 bis 30 min gehalten, und anschließend mit einer Geschwindigkeit von 2 K/min oder weniger auf 1000°C, und ab 1000°C mit einer Geschwindigkeit von 10 K/min oder weniger abgekühlt.
(b) Es wurde eine BFA-Analyse mittels eines SIRD-Systems der PVA Metrology & Plasma Solutions GmbH durchgeführt, und zwar auf kreisförmigen Teilflächen mit einem Radius von 40 mm um die Auflagestellen, wo während der Wärmebehandlung der Kontakt zwischen der Halbleiterscheibe und den Fingern des Boots bestand. Der kürzeste Abstand der drei Teilflächen zum Rand der Halbleiterscheibe betrug nicht weniger als 1 mm und nicht mehr als 33 % des Durchmessers der Halbleiterscheibe, vorzugsweise ca. 10 mm.
(c) Die vom SIRD-System gelieferte hochpassgefilterte Depolarisations-Karte wurde in den Teilflächen ausgewertet und dafür ein Schwellwert-Bereich der Depolarisation von ± 10 DU (depolarization units) festgelegt. Im Zuge der BFA-Analyse wird die Depolarisation für Zellen eines Gitters bestimmt, das virtuell über die Depolarisations-Karte gelegt ist. Das Gitter besteht vorzugsweise aus quadratischen Zellen mit einer Kantenlänge von vorzugsweise 2 mm. Das Ergebnis der BFA-Analyse ist das prozentuale Verhältnis bcf (bad cell fraction), welche dem Verhältnis der Anzahl der schlechten Zellen, welche außerhalb des Schwellenwert-Bereiches liegen, in den drei Teilflächen zur Anzahl der Zellen der drei Teilflächen entspricht. Zellen, die nicht vollständig in einer Teilfläche liegen, werden nur mitgezählt, wenn die Fläche der betroffenen Zelle, die sich mit der Teilfläche überschneidet, mindestens 50% beträgt. Wenn das prozentuale Verhältnis bfc weniger als 1% beträgt, so wird die Scheibe als frei von thermisch induzierten Versetzungen betrachtet.

### Detaillierte Beschreibung eines Ausführungsbeispiels

Zunächst wurde gemäß der Czochralski-Methode in einer Atmosphäre aus Argon und Wasserstoff (Partialdruck von Wasserstoff: 25 - 35 Pa) ein Einkristall aus Silizium mit einer (100)-Orientierung gezogen. Dabei wurde ein Quarztiegel mit einer Wandhöhe von über 58 cm und einem Durchmesser von 32 Zoll verwendet. Der zylindrische Abschnitt des Einkristalls hatte dabei einen Durchmesser von 313 mm. Die Drehrichtung des Tiegels wurde während des Ziehens des zylindrischen Abschnitts des Einkristalls mit einer Periodendauer von 25 s gewechselt, wobei die Amplitude der Drehgeschwindigkeit ab einer Länge, die 20 bis 25% der Gesamtlänge des Kristalls entsprach, kontinuierlich bis auf 6 U/min erhöht wurde. Die mittlere Drehgeschwindigkeit des Tiegels betrug 0,6 U/min. Der Koeffizient v/G der Ziehgeschwindigkeit v und des thermischen Gradienten an der Grenzfläche G wies während des Ziehens des zylindrischen Abschnitts drei Rampen entlang der Ziehachse auf. Das Ziehen des zylindrischen Abschnitts des Einkristalls erfolgte mit einer Ziehgeschwindigkeit von nicht weniger als 0,48 mm/min und nicht mehr als 0,50 mm/min.

In einem anschließenden Schleifschritt wurde der Durchmesser des zylindrischen Abschnittes des Einkristallstabs verringert. Der zylindrische Abschnitt des Einkristallstabs wurde zu polierten Scheiben mit einem Durchmesser von 301 mm und einer Dicke von 780 µm verarbeitet und einer chemischen Reinigung unterzogen. Wegen der beim Ziehen gewählten Bedingungen bezüglich des Quotienten v/G bestand das Kristallgitter der Halbleiterscheiben mit einem Durchmesser von 301 mm ausschließlich aus N-Gebiet, mit einem Anteil an Nᵥ-Domäne und einem Anteil an Nᵢ-Domäne. Die Halbleiterscheiben wurden anschließend einer Reihe von RTA-Behandlungen unterzogen.

In der ersten RTA-Behandlung wurde die Halbleiterscheibe über einen Zeitraum von nicht weniger als 10 s und nicht mehr als 20 s bei einer Temperatur in einem ersten Temperaturbereich von nicht weniger als 700 °C und nicht mehr als 1000 °C gehalten und dabei einer ersten Atmosphäre aus Argon und Ammoniak im Volumen-Verhältnis von nicht weniger als 1:1.5 und nicht mehr als 1:0,9 ausgesetzt.

In der zweiten RTA-Behandlung wurde die Halbleiterscheibe über einen Zeitraum von nicht weniger als 20 s und nicht mehr als 30 s bei einer Temperatur in einem zweiten Temperaturbereich von nicht weniger als 1180 °C und nicht mehr als 1220 °C gehalten und dabei einer zweiten Atmosphäre aus Argon ausgesetzt.

In der dritten RTA-Behandlung wurde die Halbleiterscheibe über einen Zeitraum von nicht weniger als 10 s und nicht mehr als 20 s bei einer Temperatur in einem dritten Temperaturbereich von nicht weniger als 1160 °C und nicht mehr als 1170 °C gehalten und dabei einer dritten Atmosphäre aus Argon und Ammoniak im Volumen-Verhältnis von nicht weniger als 9:10 und nicht mehr als 2,75:2 ausgesetzt.

Die Halbleiterscheibe wurde bis zu einer Temperatur von 1200°C mit einer Geschwindigkeit von 60 K/s bis 70 K/s und ab einer Temperatur von 1200°C mit einer Geschwindigkeit von 15 K/s bis 20 K/s erhitzt. Nach der letzten RTA-Behandlung wurde die Halbleiterscheibe mit einer Geschwindigkeit von 30 K/s von der Zieltemperatur der letzten RTA-Behandlung abgekühlt.

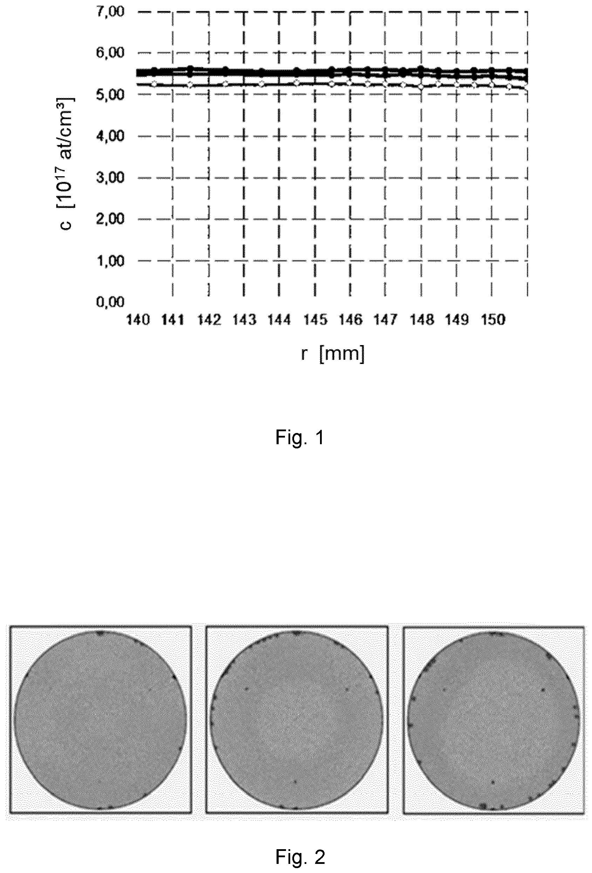

Fig. 1 zeigt, dass die so hergestellten Halbeiterscheiben einerseits die gewünschte Konzentration an interstitiellem Sauerstoff und andererseits die gewünschte geringe Variation der Konzentration an interstitiellem Sauerstoff in einem ringförmigen Randbereich, der 147 mm bis 150 mm von der Rotationsachse der Halbleiterscheibe entfernt ist, aufweist. Dies Messung erfolgte mittels LT-FTIR. Fig. 2 zeigt mittels SIRD-Messung, dass nach einem mechanischen Stresstest in einem Vertikalofen von ASM International NV, in welchem jede Halbleiterscheibe auf drei Fingern eines Boots (long finger boat) des Herstellers Ferrotec Materials Technologies Corporation auflag, wobei die Halbleiterscheiben in einem Randbereich mit einer radialen Breite von 10 mm mit einer Temperatur von 1150°C um 5 °C stärker erhitzt wurden als im von Randbereich umschlossenen Zentrumsbereich, nur wenig Stress im Randbereich erzeugt wurde. In dem oben beschriebenen Verfahren zum Testen der Widerstandsfähigkeit gegen thermisch induzierte Versetzungen wurde ein prozentuales Verhältnis bfc von weniger als 1% ermittelt, so dass die Scheibe als frei von thermisch induzierten Versetzungen betrachtet wurde (Schwellwert-Bereich der Depolarisation ± 10 DU).

### Beschreibung eines Vergleichsbeispiel

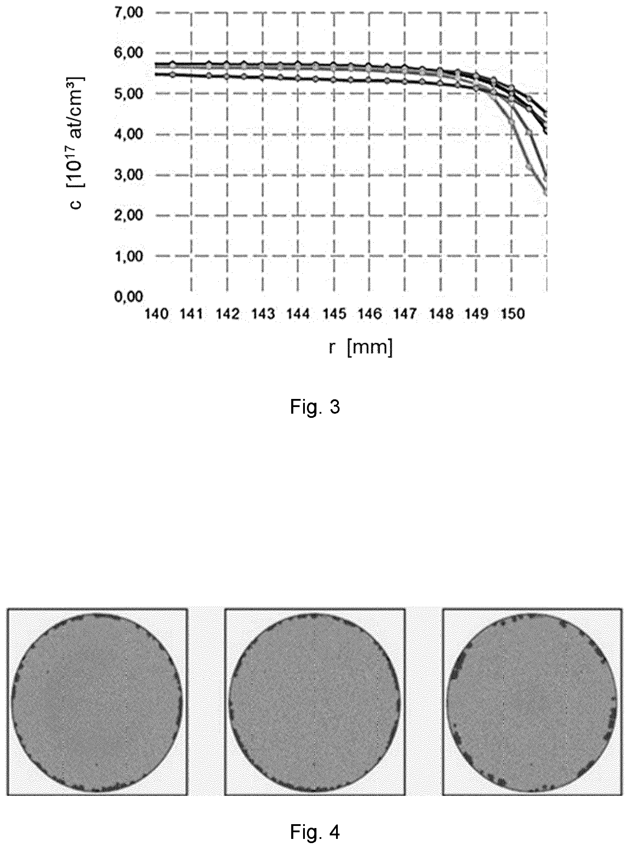

Im Rahmen eines Vergleichsbeispiels wurden mehrere Halbleiterscheiben mit dem in der EP 4 151 782 B1 beschriebenen Verfahren hergestellt. Eine Messung der Konzentration an interstitiellem Sauerstoff mittels LT-FTIR zeigte einen im Vergleich zum Ausführungsbeispiel 1 stärkeren Randabfall der Sauerstoffkonzentration, wie in Fig. 3 zu sehen ist. So fiel die Konzentration an interstitiellem Sauerstoff in einem ringförmigen Randbereich, der 147 mm bis 150 mm von der Rotationsachse der Halbleiterscheibe entfernt ist, um deutlich mehr als 0,2 × 10¹⁷ Atome/cm³ ab. Außerdem wurden die Scheiben dem im Ausführungsbeispiel 1 beschriebenen Test der Widerstandsfähigkeit gegen thermisch induzierte Versetzungen unterzogen, welcher einen mechanischen Stresstest mit anschließender SIRD-Messung und Auswertung umfasst. Dabei wurde ein prozentuales Verhältnis bfc von mehr als 5 % ermittelt, so dass die Scheibe eine erhebliche Anzahl von thermisch induzierten Versetzungen aufwies (Schwellwert-Bereich der Depolarisation ± 10 DU). Fig. 4 zeigt mittels SIRD-Messung, dass nach dem mechanischen Stresstest Stress und damit Defekte im Randbereich in einer höheren Konzentration als im Ausführungsbeispiel vorlagen.

## Patentansprüche

1. Halbleiterscheibe aus einkristallinem Silizium mit einer Vorderseite und einer Rückseite, bestehend aus
einem ringförmigen Randbereich am äußeren Rand der Scheibe, in dem sich die Dicke der Scheibe in Radialauswärtsrichtung verjüngt; und
einem Bereich mit konstanter axialer Dicke bestehend aus N-Gebiet, der innerhalb des ringförmigen Randbereichs angeordnet ist;
wobei der Bereich mit konstanter axialer Dicke einen oberflächennahen Bereich an der Vorderseite, einen oberflächennahen Bereich an der Rückseite und einen zwischen den oberflächennahen Bereichen angeordneten inneren Bereich umfasst; und
der oberflächennahe Bereich an der Vorderseite sich von der Oberfläche der Vorderseite in axialer Richtung bis in eine Tiefe von nicht weniger als 50 µm erstreckt;
**dadurch gekennzeichnet, dass**
eine Konzentration an interstitiellem Sauerstoff im gesamten inneren Bereich nicht weniger als 5,2 × 10¹⁷ Atome/cm³ und nicht mehr als 5,8 × 10¹⁷ Atome/cm³ beträgt und in radialer Richtung um nicht mehr als 0,2 × 10¹⁷ Atome/cm³ variiert; und
eine Konzentration an Stickstoff im oberflächennahen Bereich an der Vorderseite in axialer Richtung von der Oberfläche ins Innere der Halbleiterscheibe abnimmt und in einer Tiefe von 5 µm von der Oberfläche nicht weniger als 1.0 × 10¹⁴ Atome/cm³ und nicht mehr als 1,7 × 10¹⁵ Atome/cm³ beträgt.

2. Halbleiterscheibe nach dem Anspruch 1, **dadurch gekennzeichnet, dass** die Konzentration an interstitiellem Sauerstoff im gesamten inneren Bereich in radialer Richtung um nicht mehr als 0,1 × 10¹⁷ Atome/cm³ variiert.

3. Halbleiterscheibe nach dem Anspruch 1 oder 2, **dadurch gekennzeichnet, dass** die Konzentration an interstitiellem Sauerstoff im gesamten inneren Bereich nach einer Wärmebehandlung nicht weniger als 4,40 × 10¹⁷ Atome/cm³ beträgt, wobei die Wärmebehandlung die folgenden Schritte umfasst:
einen ersten Schritt, in dem die Halbleiterscheibe einer Atmosphäre aus einer Mischung von Sauerstoff und Stickstoff mit einem Volumen-Verhältnis von O₂:N₂ von 1:10 über einen Zeitraum von 4 Stunden bei einer Temperatur von 800 °C ausgesetzt wird; und
einen zweiten Schritt, in dem die Halbleiterscheibe einer Atmosphäre aus einer Mischung von Sauerstoff und Stickstoff mit einem Volumen-Verhältnis von O₂:N₂ von 1:10 über einen Zeitraum von 16 Stunden bei einer Temperatur von 1000 °C ausgesetzt wird.

4. Halbleiterscheibe nach einem der Ansprüche 1 bis 3, **dadurch gekennzeichnet, dass** die Konzentration an interstitiellem Sauerstoff im gesamten inneren Bereich nach der im Anspruch 3 definierte Wärmebehandlung um nicht mehr als 1,30 × 10¹⁷ Atome/cm³ geringer ist als vor der Wärmebehandlung.

5. Halbleiterscheibe nach einem der Ansprüche 1 bis 4, **dadurch gekennzeichnet, dass** die Konzentration an interstitiellem Sauerstoff im gesamten inneren Bereich nach der im Anspruch 3 definierte Wärmebehandlung um nicht mehr als 1,00 × 10¹⁷ Atome/cm³ geringer ist als vor der Wärmebehandlung.

6. Halbleiterscheibe nach einem der Ansprüche 1 bis 5, **dadurch gekennzeichnet, dass** der oberflächennahe Bereich an der Vorderseite eine höhere Stickstoffkonzentration aufweist als der oberflächennahe Bereich an der Rückseite.

7. Halbleiterscheibe nach einem der Ansprüche 1 bis 6, **dadurch gekennzeichnet, dass** der oberflächennahe Bereich an der Vorderseite eine Denuded Zone aufweist, die sich in axialer Richtung von der Oberfläche der Vorderseite bis zu einer Tiefe von nicht weniger als 10 µm ins Innere der Halbleiterscheibe erstreckt; und unter der Denuded Zone ein Bereich mit einer Dichte von BMDs von 1,1 × 10¹⁰ cm⁻³ bis 1,3 × 10¹⁰ cm⁻³ angeordnet ist.

8. Halbleiterscheibe nach einem der Ansprüche 1 bis 7, **dadurch gekennzeichnet, dass** die Konzentration an Kohlenstoff in dem Bereich mit konstanter axialer Dicke an keiner Stelle mehr als 5,0 × 10¹⁵ Atome/cm³ beträgt.

9. Halbleiterscheibe nach einem der Ansprüche 1 bis 8, wobei das N-Gebiet **dadurch gekennzeichnet ist, dass** in ihm keine Agglomerate von Silizium-Zwischengitteratomen oder Leerstellen mit einem Durchmesser von mehr als 20 nm vorhanden sind.

10. Halbleiterscheibe nach einem der Ansprüche 1 bis 9, wobei das N-Gebiet **dadurch gekennzeichnet ist, dass** in ihm keine Agglomerate von Silizium-Zwischengitteratomen oder Leerstellen mit einem Durchmesser von mehr als 15 nm vorhanden sind.

11. Halbleiterscheibe nach einem der Ansprüche 1 bis 10, **dadurch gekennzeichnet, dass** die Halbleiterscheibe in dem in der Beschreibung aufgeführten Verfahren zum Testen der Widerstandsfähigkeit gegen thermisch induzierte Versetzungen keine solchen Versetzungen zeigt.

12. Halbleiterscheibe nach einem der Ansprüche 1 bis 11, **dadurch gekennzeichnet, dass** die Halbleiterscheibe eine Konzentration an COPs mit einer Größe von nicht mehr als 15 nm von nicht mehr als 3,0 × 10⁵ cm⁻³ aufweist.

13. Halbleiterscheibe nach einem der Ansprüche 1 bis 12, **dadurch gekennzeichnet, dass** die Halbleiterscheibe einen Durchmesser von nicht weniger als 300 mm und nicht mehr als 310 mm und eine Dicke von nicht weniger als 500 µm und nicht mehr als 1500 µm aufweist.
